(19) Europäisches Patentamt
European Patent Office
Office européen des brevets

(11) **EP 1 153 430 B1**

(12) **EUROPÄISCHE PATENTSCHRIFT**

(45) Veröffentlichungstag und Bekanntmachung des Hinweises auf die Patenterteilung:
**10.11.2004 Patentblatt 2004/46**

(21) Anmeldenummer: **00908927.7**

(22) Anmeldetag: **11.01.2000**

(51) Int Cl.⁷: **H01L 21/768**, H01L 21/288

(86) Internationale Anmeldenummer:
**PCT/DE2000/000133**

(87) Internationale Veröffentlichungsnummer:
**WO 2000/044042 (27.07.2000 Gazette 2000/30)**

(54) **VERFAHREN ZUM GALVANISCHEN BILDEN VON LEITERSTRUKTUREN AUS HOCHREINEM KUPFER BEI DER HERSTELLUNG VON INTEGRIERTEN SCHALTUNGEN**

METHOD FOR GALVANICALLY FORMING CONDUCTOR STRUCTURES OF HIGH-PURITY COPPER IN THE PRODUCTION OF INTEGRATED CIRCUITS

PROCEDE POUR LA FORMATION GALVANIQUE DE STRUCTURES CONDUCTRICES EN CUIVRE DE GRANDE PURETE LORS DE LA FABRICATION DE CIRCUITS INTEGRES

(84) Benannte Vertragsstaaten:
**AT BE CH CY DE DK ES FI FR GB GR IE IT LI LU MC NL PT SE**

(30) Priorität: **21.01.1999 DE 19903178**
**26.03.1999 DE 19915146**

(43) Veröffentlichungstag der Anmeldung:
**14.11.2001 Patentblatt 2001/46**

(73) Patentinhaber: **ATOTECH Deutschland GmbH**
**10553 Berlin (DE)**

(72) Erfinder:
• **MEYER, Heinrich**
  **D-14109 Berlin (DE)**
• **THIES, Andreas**
  **D-14167 Berlin (DE)**

(74) Vertreter: **Effert, Bressel und Kollegen**
  **Radickestrasse 48**
  **12489 Berlin (DE)**

(56) Entgegenhaltungen:
**DE-A- 19 545 231**

**Beschreibung**

Die Erfindung betrifft ein Verfahren zum galvanischen Bilden von Leiterstrukturen aus hochreinem Kupfer, beispielsweise von Leiterbahnen, Durchgangslöchern, Verbindungskontaktierungen und Anschlußplätzen, auf mit Vertiefungen versehenen Oberflächen von Halbleitersubstraten (Wafern) bei der Herstellung von integrierten Schaltungen, insbesondere in Fällen, in denen die Vertiefungen ein hohes Aspektverhältnis aufweisen.

Zur Herstellung integrierter Schaltungen wird die sogenannte Silizium-Planartechnik eingesetzt, bei der Epitaxie- und Dotierungsverfahren angewendet werden. Hierzu werden einkristalline Siliziumscheiben, sogenannte Wafer, mit physikalischen Methoden bearbeitet, um im Mikrometer- und seit einiger Zeit auch im Sub-Mikrometerbereich (derzeit 0,25 μm) unterschiedlich leitfähige Bereiche auf der Siliziumoberfläche zu bilden.

Der Herstellungsprozeß läßt sich in drei Etappen unterteilen:

(a) Herstellung von Transistoren und deren gegenseitige Oxidation; dieser Prozeß wird auch FEOL (Front End of Line) bezeichnet ("Technologie hochintegrierter Schaltungen", D.Widmann, H.Mader, H.Friedrich, 2.Auflage, Springer-Verlag, 1996; "VLSI-Electronic Microstructure Science", Norman G. Einspruch, Editor, insbes. Vol. 19 "Advanced CMOS Technology", J.M.Pimbley, M.Ghezzo, H.G.Parks, D.M.Brown, Academic Press, New York, 1989);
(b) Kontaktierung und Verbindung der einzelnen mono- und polykristallinen Siliziumbereiche des FOEL-Teils gemäß der gewünschten integrierten Schaltung;
(c) Passivierung bzw. Schutz gegen mechanische Beschädigung oder gegen das Eindringen von Fremdstoffen.

Die Transistoren werden in der zweiten Etappe in der Regel durch Mehrlagenmetallisierung kontaktiert und miteinander verbunden, wobei zur Isolation der hierfür gebildeten Leiterzüge üblicherweise das dielektrische Siliziumdioxid verwendet wird.

Zur Herstellung der Leiterbahnen, der Verbindungskontaktierungslöcher und der Anschlußplätze wird seit langem eine im allgemeinen 1 μm dicke Aluminiumschicht mit physikalischen Methoden, beispielsweise einem Aufdampf(Elektronenstrahlverdampfungs-) oder einem Sputterverfahren, aufgebracht. Diese wird durch geeignete Ätzverfahren unter Verwendung eines Photoresists nachträglich strukturiert.

Aluminium wird in der älteren Literatur als günstigste Alternative der verfügbaren Materialien zur Herstellung der Leiterbahnen, Verbindungskontaktierungen und Anschlußplätze beschrieben. Beispielsweise werden Anforderungen an diese Schicht in "Integrierte Bipolarschaltungen" von H.-M.Rein und R.Ranfft, Springer-Verlag, Berlin, 1980 angegeben. Die dort genannten Probleme werden durch bestimmte Verfahrensoptimierungen zwar minimiert, können jedoch nicht völlig vermieden werden.

in jüngerer Zeit ist es gelungen, Aluminium durch galvanisch abgeschiedenes Kupfer zu ersetzen (IEEE-Spektrum, January 1998, Linda Geppert, "Solid State", Seiten 23 bis 28). insbesondere wegen der höheren elektrischen Leitfähigkeit, höheren Wärmebeständigkeit sowie Diffusions- und Migrationsfestigkeit hat sich Kupfer als Alternative zu Aluminium als bevorzugtes Material herausgestellt. Hierzu wird die sogenannte "Damaszene"-Technik angewendet (IEEE-Spektrum, January 1998, Linda Geppert, "Solid State", Seiten 23 bis 28 und P.C.Andricacos et al. in IBM J. Res. Developm., Vol. 42, Seiten 567 bis 574). Zunächst wird dazu eine Dielektrikumschicht auf das Halbleitersubstrat aufgebracht. Die erforderlichen Löcher (vias) und Gräben (trenches) werden zur Aufnahme der gewünschten Leiterstrukturen geätzt, üblicherweise mit einem Trockenätzverfahren. Nach dem Aufbringen einer Diffusionsbarriere (meist Titannitrid, Tantal oder Tantalnitrid) und einer Leitschicht (meist gesputtertes Kupfer) werden die Vertiefungen, d.h. die Löcher und Gräben, galvanisch mit dem sogenannten trench-filling-Prozeß aufgefüllt. Da das Kupfer dabei ganzflächig abgeschieden wird, muß der Überschuß an den unerwünschten Stellen nachträglich wieder entfernt werden. Dies geschieht mit dem sogenannten CMP-Prozeß (Chemisch-mechanisches Polieren). Durch Wiederholung des Prozesses, d.h. mehrmaliges Aufbringen des Dielektrikums (beispielsweise von Siliziumdioxid) und Bilden der Vertiefungen durch Ätzen, lassen sich Mehrlagenschaltungen herstellen.

Nachfolgend sind die technischen Anforderungen an den galvanischen Kupferabscheideprozeß wiedergegeben:

(a) Konstante Schichtdicke über die gesamte Waferoberfläche (Planarität); je geringer die Abweichungen von der Sollschichtdicke sind, desto einfacher ist der nachfolgende CMP-Prozeß;
(b) Zuverlässiges trench-filling auch sehr tiefer Gräben mit hohem Aspektverhältnis; in der Zukunft werden Aspektverhältnisse von 1 : 10 erwartet;
(c) Höchstmögliche elektrische Leitfähigkeit und damit zwangsläufig höchste Reinheit des abgeschiedenen Kupfers; beispielsweise wird gefordert, daß die Summe aller Verunreinigungen in der Kupferschicht weniger als 100 ppm ($\Delta$ 0,01 Gew.-%) beträgt.

Es hat sich herausgestellt, daß diese Technik zur Herstellung der Leiterbahnen, Verbindungskontaktierungen und Anschlußplätze gegenüber dem bisher verwendeten Aluminium Vorteile bietet. Allerdings zeigen sich nunmehr auch Nachteile bei Anwendung der galvanotechnischen Verfahren nach dem Stand der Technik, die zu einer Verringerung der Ausbeute oder zumindest zu hohen Kosten bei der Herstellung führen:

(a) Bei Verwendung von löslichen Anoden tritt der Nachteil auf, daß sich die Geometrie der Anoden während des Abscheideprozesses langsam ändert, da sich die Anoden beim Abscheideprozeß auflösen, so daß keine Dimensionsstabilität und damit auch keine konstante Feldlinienverteilung zwischen den Anoden und den Wafern erreicht werden kann. Um diesem Problem zumindest teilweise zu begegnen, werden zwar inerte Behälter für stückiges Anodengut eingesetzt, so daß sich die Abmessungen der Anoden während des Abscheideprozesses nicht zu sehr verändern und aufgelöste Anoden relativ leicht wieder ersetzt werden können. Während der Ergänzung dieser sogenannten Anodenkörbe mit frischem Anodenmaterial muß der Abscheideprozeß jedoch stillgelegt werden, so daß bei einer erneuten Inbetriebnahme des Prozesses wegen der damit einhergehenden Veränderungen des Bades zunächst nur Probemuster bearbeitet werden können, um wieder konstante stationäre Verhältnisse des Prozesses zu erreichen. Außerdem führt jeder Anodenwechsel zu einer Kontamination des Bades durch Ablösen von Verunreinigungen von den Anoden (Anodenschlamm). Auch von daher ist eine längere Einarbeitungszeit nach dem Anoden-Nachfüllen erforderlich.

(b) Außerdem verarmt im Bad gelöstes Kupfer während der Kupferabscheidung. Werden daraufhin Kupfersalze im Bad ergänzt, so führt dies zu einem schwankenden Kupfergehalt in der Lösung. Um diesen wiederum konstant zu halten, muß ein erheblicher regelungstechnischer Aufwand getrieben werden.

(c) Ferner besteht bei Verwendung unlöslicher Anoden die Gefahr, daß an den Anoden Gase entwickelt werden. Diese Gase lösen sich beim Abscheideprozeß von den üblicherweise horizontal gehaltenen Anoden ab und steigen in der Abscheidelösung nach oben. Dort treffen sie auf die ebenfalls üblicherweise horizontal gehaltenen und der Anode gegenüberliegenden Wafer und lagern sich an deren unterer Oberfläche ab. Die Stellen auf der Waferoberfläche, an denen sich die Gasblasen anlagern, werden gegen das homogene elektrische Feld im Bad abgeschirmt, so daß dort keine Kupferabscheidung stattfinden kann. Die derart gestörten Bereiche können zum Ausschuß des Wafers oder zumindest von Teilen des Wafers führen.

(d) Außerdem werden unlösliche Anoden bei der Anwendung von Pulstechniken zerstört, indem die Edelmetallbeschichtungen aufgelöst werden.

(e) Ferner dürfen sich in den mit Kupfer gefüllten Vertiefungen keine Phasengrenzen durch eine vom Boden der Vertiefungen und/oder den Seitenflächen her wachsende Kupferschicht oder sogar Hohlräume im Kupfer bilden. Derartiges ist beispielsweise von P.C.Andricacos et al., ibid beschrieben worden. Eine Verbesserung wurde dort durch Zugabe von Zusätzen zum Abscheidebad erreicht, die zur Verbesserung der Schichteigenschaften dienen.

(f) Ein weiterer wesentlicher Nachteil besteht darin, daß die aufgebrachte Kupferschicht sehr eben sein muß. Da die Kupferschicht sowohl in den Vertiefungen als auch auf den erhabenen Stellen des Wafers gebildet wird, entsteht eine sehr ungleichmäßig dicke Kupferschicht. Beim Einsatz der Damaszene-Technik wird die Oberfläche mit dem CMP-Verfahren geglättet. Dabei kann die erhöhte Polierrate (dishing) über den Strukturen (trenches und vias) von Nachteil sein. in der Veröffentlichung von P.C.Andricacos et al., ibid ist als bestes Ergebnis eine Kupferschicht gezeigt, bei der über den Vertiefungen noch eine leichte Einkerbung vorliegt. Auch diese führt beim Polieren zu Problemen.

Der vorliegenden Erfindung liegt von daher das Problem zugrunde, die Nachteile der bekannten Verfahren zu vermeiden und insbesondere die bei Verwendung der günstigeren unlöslichen Anoden erhaltene erhöhte Kontamination der Kupferüberzüge zu minimieren. Außerdem soll vermieden werden, daß sich beim Bilden der Kupferstrukturen in Vertiefungen mit einem großen Aspektverhältnis Elektrolyteinschlüsse in der Kupferstruktur bilden. Darüber hinaus sollen die Probleme, die sich durch die Ergänzung der Kupfersalze in der Abscheidelösung ergeben, gelöst werden. Sehr wichtig ist auch die Vermeidung des dishing-Problems.

Gelöst werden diese Probleme durch das Verfahren nach Anspruch 1. Bevorzugte Ausführungsformen der Erfindung sind in den Unteransprüchen angegeben.

Das erfindungsgemäße Verfahren zum galvanischen Bilden von Leiterstrukturen aus hochreinem Kupfer auf den Halbleitersubstraten (Wafern) bei der Herstellung von integrierten Schaltungen umfaßt folgende wesentliche Verfahrensschritte:

a. Füllen der an den Oberflächen der Wafer liegenden Vertiefungen mit einer vorzugsweise 0,02 µm bis 0,3 µm dicken, ganzflächigen Grundmetallschicht zur Herstellung ausreichender Leitfähigkeit (plating base), wobei vorzugsweise ein physikalisches Metallabscheideverfahren und/oder ein CVD-Verfahren und/oder ein PECVD-Verfahren eingesetzt wird;

b. ganzflächiges Abscheiden von Kupferschichten mit gleichmäßiger Schichtdicke auf der Grundmetallschicht mit einem galvanischen Metallabscheideverfahren in einem Kupferabscheidebad,

> i. wobei das Kupferabscheidebad mindestens eine Kupferionenquelle, mindestens eine Additivverbindung zur Steuerung der physikalisch-mechanischen Eigenschaften der Kupferschichten sowie Fe(II)- und/oder Fe(III)-Verbindungen enthält und
> ii. wobei zwischen den Wafern und dimensionsstabilen, in dem Bad unlöslichen und mit diesem in Kontakt gebrachten Gegenelektroden eine elektrische Spannung angelegt wird, so daß zwischen den Wafern und den Gegenelektroden ein elektrischer Strom fließt, und wobei die elektrische Spannung und der fließende Strom entweder konstant sind oder in Form von uni- oder bipolaren Pulsen zeitlich verändert werden;

c. Strukturieren der Kupferschicht, vorzugsweise durch ein CMP-Verfahren.

Mit dem erfindungsgemäßen Verfahren ist es möglich, die Nachteile der verschiedenen bekannten Verfahrensvarianten zur Herstellung von integrierten Schaltungen erstmalig zu vermeiden.

Es wurde überraschend gefunden, daß durch Zusatz von Fe(II)/Fe(III)-Verbindungen nicht nur - wie in DE 195 45 231 A1 für die Anwendung in der Leiterplattentechnik beschrieben - die vorgenannten Nachteile (a) bis (d) behoben werden können, sondern daß gegen jede Erwartung auch die Reinheit der Kupferschichten ausgezeichnet ist und daß vor allem kein Eisen in das Kupfer eingebaut wird, so daß das abgeschiedene Kupfer alle Spezifikationen erfüllt, insbesondere auch die Forderung nach gutem trench-filling, ein Phänomen, für das es bislang keine plausible wissenschaftliche Erklärung gibt. Besonders überraschend war die Beobachtung, daß sich sogar eine.etwas dickere Metallschicht über den Vertiefungen bildete als über den erhabenen Strukturen, so daß der nachteilige Effekt des "dishing" kompensiert wird.

Die Vorteile im einzelnen:

(a) Entgegen aller Erwartung hat sich herausgestellt, daß sich der Kontaminationsgrad der erzeugten Kupferstrukturen bei Verwendung von dimensionsstabilen, unlöslichen Anoden deutlich absenken läßt, obwohl dem Abscheidebad weitere Bestandteile, nämlich Eisensalze, zugegeben werden. Typischerweise enthält das Kupfer nur höchstens 10 ppm Eisen. Das gefundene Ergebnis steht in Widerspruch zu der Erwartung, daß durch Zugabe weiterer Stoffe zum Abscheidebad üblicherweise auch stärker kontaminierte Überzüge erhalten werden. Daher hat bislang die Forderung bestanden, möglichst reine Chemikalien für die Herstellung von integrierten Schaltungen zu verwenden. Im allgemeinen wird nämlich davon ausgegangen, daß ausschließlich höchstreine Chemikalien bei der Herstellung von integrierten Schaltungen eingesetzt werden dürfen, um Kontaminationen des höchstempfindlichen Silizium zu vermeiden. Diese Anforderung beruht darauf, daß der Kontaminationsgrad der elektrischen Bereiche in einer integrierten Schaltung umso größer ist, je größer der Kontaminationsgrad der für die Herstellung der Schaltung verwendeten Chemikalien ist. Eine Kontamination der elektrischen Bereiche im Silizium ist auf jeden Fall zu vermeiden, da selbst bei geringster Verunreinigung dieser Bereiche nachteilige Folgen und wahrscheinlich sogar ein Totalausfall der Schaltung zu befürchten sind.

Verglichen mit Herstelltechniken für integrierte Schaltungen werden in der Leiterplattentechnik nicht annähernd so hohe Anforderungen an die Reinheit der Kupferschicht gestellt. Daher konnte der Einsatz von Eisensalzen in diesem Fall problemlos hingenommen werden.

Darüber hinaus ist bekannt, daß sich Eisen aus galvanotechnischen Bädern zum Abscheiden von Kupferlegierungen, die Eisen enthalten, als Legierungsmetall mit abscheidet. Beispielsweise ist in "Electrodeposition of high Ms cobaltiron-copper alloys for recording heads", J.W.Chang, P.C.Andricacos, B.Petek, L.T.Romankiw, Proc. - Electrochem. Soc. (1992), 92-10 (Proc. Int. Symp. Magn. Mater. Processes, Devices, 2nd, 1991), Seiten 275 bis 287 für die Abscheidung einer Kupfer und Eisen enthaltenden Legierung beschrieben, daß ein Gehalt von Eisen im Abscheidebad (15 g/l $FeSO_4 \cdot 7\ H_2O$), der im wesentlichen dem Eisengehalt im erfindungsgemäßen Kupferabscheidebad entspricht, zu einem erheblichen Eisengehalt in der Legierung führt. Auch in anderen Veröffentlichungen wird auf die galvanische Abscheidung von Eisen enthaltenden Legierungen hingewiesen, beispielsweise in "pH-changes at the cathode during electrolysis of nickel, iron, and copper and their alloys and a simple technique for measuring pH changes at electrodes", L.T.Romankiw, Proc. - Electrochem. Soc. (1987), 87-17 (Proc. Symp. Electrodeposition Technol., Theory Pract.), 301-25.

(b) Ferner wird eine sehr gleichmäßige Kupferschichtdicke an allen Stellen des Wafers erreicht.

Vertiefungen mit üblicherweise sehr geringer Breite bzw. einem sehr geringen Durchmesser werden sehr schnell vollständig mit Metall gefüllt. Über derartigen Vertiefungen wird sogar eine etwas größere Dicke_des Metalls erreicht als über den erhabenen Strukturen. Daher ist der Aufwand beim nachfolgenden Polieren mit dem CMP-Verfahren nicht sehr groß. Die Vertiefungen haben im allgemeinen eine Breite bzw. einen Durchmesser von 0,15 μm bis 0,5 μm. Deren Tiefe beträgt üblicherweise etwa 1 μm.

Die durch Herstellung nach dem erfindungsgemäßen Verfahren erhaltenen Kupferschichten sind bei Vertiefungen mit größeren lateralen Abmessungen im Gegensatz zu den bekannten Verfahren an den Eintrittskanten zu den zu metallisierenden Vertiefungen ebenso dick wie an den Seitenwänden und am Boden der Vertiefungen. Die Kupferschicht folgt weitgehend der Oberflächenkontur der Waferoberfläche. Dadurch wird der Nachteil vermieden, daß der Querschnitt der Vertiefungen am oberen Rand bereits vollständig mit Kupfer gefüllt wird, während sich im unteren Bereich der Vertiefungen noch Abscheidelösung befindet. Die mit einem derartigen Einschluß von Elektrolyt einhergehenden Probleme, beispielsweise explosionsartiges Entweichen der eingeschlossenen Flüssigkeit beim Erwärmen der Schaltung, Diffusion von Verunreinigungen durch das Kupfer, werden dadurch vollständig vermieden. Es wird eine gleichmäßig mit Kupfer ausgefüllte Metallstruktur erhalten, die die üblichen Anforderungen erfüllt, die bei der Herstellung von integrierten Schaltungen bestehen.

(c) Des weiteren können die Nachteile, die sich durch den Einsatz von löslichen (Kupfer-)anoden ergeben, vermieden werden. insbesondere wird eine reproduzierbare Feldlinienverteilung innerhalb des Abscheidebades erreicht. Dagegen ändert sich die Geometrie löslicher Anoden durch die Auflösung ständig, so daß zumindest im äußeren Bereich der den Anoden gegenüberliegenden Wafer keine zeitstabile Feldlinienverteilung erhalten werden kann. Durch Einsatz der dimensionsstabilen Anoden ist es daher nunmehr möglich, auch größere Wafer herzustellen als bisher.

Die bei der Ergänzung von verbrauchtem Anodenmaterial auftretenden Probleme (Kontamination des Bades durch Anodenschlamm und durch andere Verunreinigungen, Betriebsunterbrechungen durch Abschalten des Bades und erneutes Anfahren und Einfahren des Bades) können beim Einsatz unlöslicher Anoden ebenfalls vermieden werden.

(d) Überraschend ist auch, daß mit dem erfindungsgemäßen Verfahren problemlos Vertiefungen mit sehr hohen Aspektverhältnissen mit Kupfer gefüllt werden können, ohne daß sich Gas- oder Flüssigkeitseinschlüsse in dem Kupferleiterzug bilden würden. Eine wissenschaftliche Erklärung für dieses Phänomen ist bislang noch nicht gefunden worden.

Es wurde auch beobachtet, daß manche Elektrolyte ein überraschend gutes trench-filling-Verhalten aufweisen, während mit anderen ein derartiges Ergebnis nicht erhalten werden konnte.

Vorzugsweise wird ein Pulsstrom oder Pulsspannungsverfahren eingesetzt. Beim Pulsstromverfahren wird der Strom zwischen den als Kathode polarisierten Werkstücken und den Anoden galvanostatisch eingestellt und mittels geeigneter Mittel zeitlich moduliert. Beim Pulsspannungsverfahren wird eine Spannung zwischen den Wafern und den Gegenelektroden (Anoden) potentiostatisch eingestellt und die Spannung zeitlich moduliert, so daß sich ein zeitlich veränderlicher Strom einstellt.

Vorzugsweise wird das aus der Technik als Reverse-Pulse-Verfahren bekannte Verfahren mit bipolaren Pulsen eingesetzt. Insbesondere geeignet sind solche Verfahren, bei denen die bipolaren Pulse aus einer Folge von 20 Millisekunden bis 100 Millisekunden dauernden kathodischen und 0,3 Millisekunden bis 10 Millisekunden dauernden anodischen Pulsen bestehen. In einer bevorzugten Anwendung wird der Peakstrom der anodischen Pulse auf mindestens denselben Wert eingestellt wie der Peakstrom der kathodischen Pulse. Vorzugsweise wird der Peakstrom der anodischen Pulse zwei- bis dreimal so hoch eingestellt wie der Peakstrom der kathodischen Pulse.

(e) Ferner wird verhindert, daß an den unlöslichen Anoden Gasblasen entwickelt werden. Weil als Anodenreaktion nicht Wasser zersetzt wird gemäß

$$2\,H_2O \rightarrow O_2 + 4H^+ + 4e^-$$

sondern die Reaktion

$$Fe^{2+} \rightarrow Fe^{3+} + e^-$$

stattfindet, werden die Probleme vermieden, die bei Anwendung der bekannten Verfahren mit der Ablagerung dieser Gasblasen auf den den Anoden gegenüberliegenden Wafern einhergehen. Dadurch findet eine elektrische Abschirmung einzelner Bereiche an den Waferoberflächen während der Kupferabscheidung nicht statt, so daß insgesamt eine verbesserte Ausbeute bei der Herstellung der integrierten Schaltungen erreicht wird. Darüber hinaus wird auch weniger elektrische Energie benötigt.

Erfindungsgemäß wird auch ein Verfahren zur Herstellung einer ganzflächigen hochreinen Kupferschicht auf mit Vertiefungen versehenen Halbleitersubstraten (Wafern) zur Verfügung gestellt, bei dem die obigen Verfahrensschritte a. und b. durchgeführt werden. Eine Strukturierung der Kupferschicht gemäß Verfahrensschritt c. entfällt in diesem Falle. Die vorgenannten Vorteile gelten auch für die Herstellung einer ganzflächigen Kupferschicht, da aus dieser problemlos mit bekannten Verfahren Leiterstrukturen hergestellt werden können.

Das zur Kupferabscheidung eingesetzte Bad enthält neben der mindestens einen Kupferionenquelle, vorzugsweise einem Kupfersalz mit anorganischem oder organischem Anion, beispielsweise Kupfersulfat, Kupfermethansulfonat, Kupferpyrophosphat, Kupferfluoroborat oder Kupfersulfamat, zusätzlich mindestens einen Stoff zur Erhöhung der elektrischen Leitfähigkeit des Bades, beispielsweise Schwefelsäure, Methansulfonsäure, Pyrophosphorsäure, Fluoroborsäure oder Amidoschwefelsäure.

Typische Konzentrationen dieser Grundbestandteile sind nachfolgend angegeben:

| | |
|---|---|
| Kupfersulfat ($CuSO_4 \cdot 5\,H_2O$) | 20 - 250 g/l |
| vorzugsweise | 80 - 140 g/l |
| oder | 180 - 220 g/l |
| Schwefelsäure, konz. | 50 - 350 g/l |
| vorzugsweise | 180 - 280 g/l |
| oder | 50 - 90 g/l. |

Ferner kann in der Abscheidelösung ein Chlorid enthalten sein, beispielsweise Natriumchlorid oder Salzsäure. Deren typische Konzentrationen sind nachfolgend angegeben:

| | |
|---|---|
| Chloridionen (zugegeben beispielsweise als NaCl) | 0,01 - 0.18 g/l |
| vorzugsweise | 0,03 - 0,10 g/l. |

Darüber hinaus enthält das erfindungsgemäße Bad mindestens eine Additivverbindung zur Steuerung der physikalisch-mechanischen Eigenschaften der Kupferschichten. Geeignete Additivverbindungen sind beispielsweise polymere Sauerstoff enthaltende Verbindungen, organische Schwefelverbindungen, Thioharnstoffverbindungen und polymere Phenazoniumverbindungen.

Die Additivverbindungen sind innerhalb folgender Konzentrationsbereiche in der Abscheidelösung enthalten:

| | |
|---|---|
| übliche polymere Sauerstoff enthaltende Verbindungen | 0,005 - 20 g/l |
| vorzugsweise | 0,01 - 5 g/l |
| übliche wasserlösliche organische Schwefelverbindungen | 0,0005 - 0,4 g/l |
| vorzugsweise | 0,001 - 0,15 g/l. |

In Tabelle 1 sind einige polymere Sauerstoff enthaltende Verbindungen aufgeführt.

Tabelle 1
(polymere Sauerstoff enthaltende Verbindungen)
Carboxymethylcellulose
Nonylphenol-polyglykolether
Octandiol-bis-(polyalkylenglykolether)
Octanolpolyalkylenglykolether
Ölsäure-polyglykolester
Polyethylen-propylenglykol
Polyethylenglykol
Polyethylenglykol-dimethylether
Polyoxypropylenglykol

Tabelle 1   (fortgesetzt)

(polymere Sauerstoff enthaltende Verbindungen)

Polypropylenglykol

Polyvinylalkohol

Stearinsäure-polyglykolester

Stearylalkohol-polyglykolether

β-Naphthol-polyglykolether

In Tabelle 2 sind verschiedene Schwefelverbindungen mit geeigneten funktionellen Gruppen zur Erzeugung der Wasserlöslichkeit angegeben.

Tabelle 2

(organische Schwefelverbindungen)

3-(Benzthiazolyl-2-thio)-propylsulfonsäure, Natriumsalz

3-Mercaptopropan-1-sulfonsäure, Natriumsalz

Ethylendithiodipropylsulfonsäure, Natriumsalz

Bis-(p-sulfophenyl)-disulfid, Dinatriumsalz

Bis-(ω-sulfobutyl)-disulfid, Dinatriumsalz

Bis-(ω-sulfohydroxypropyl)-disulfid, Dinatriumsalz

Bis-(ω-sulfopropyl)-disulfid, Dinatriumsalz

Bis-(ω-sulfopropyl)-sulfid, Dinatriumsalz

Methyl-(ω-sulfopropyl)-disulfid, Dinatriumsalz

Methyl-(ω-sulfopropyl)-trisulfid, Dinatriumsalz

O-Ethyl-dithiokohlensäure-S-(ω-sulfopropyl)-ester, Kaliumsalz

Thioglykolsäure

Thiophosphorsäure-O-ethyl-bis-(ω-sulfopropyl)-ester, Dinatriumsalz

Thiophosphorsäure-tris-(ω-sulfopropyl)-ester, Trinatriumsalz

Thioharnstoffverbindungen und polymere Phenazoniumverbindungen als Additivverbindungen werden in folgenden Konzentrationen eingesetzt:

|  | 0,0001 - 0,50 g/l |
|---|---|
| vorzugsweise | 0,0005 - 0,04 g/l. |

Um die erfindungsgemäßen Wirkungen bei der Anwendung des beanspruchten Verfahrens zu erreichen, sind im Bad zusätzlich Fe(II)- und/oder Fe(III)-Verbindungen enthalten. Die Konzentration dieser Stoffe ist nachfolgend angegeben:

| Eisen-(II)-sulfat (FeSO$_4\cdot$ 7H$_2$O) | 1 - 120 g/l |
|---|---|
| vorzugsweise | 20 - 80 g/Liter. |

Geeignete Eisensalze sind Eisen(II)-sulfat-Heptahydrat und Eisen(III)-sulfat-Nonahydrat, aus denen sich nach kurzer Betriebszeit das wirksame $Fe^{2+}/Fe^{3+}$-Redoxsystem bildet. Diese Salze sind hervorragend geeignet für wäßrige, saure Kupferbäder. Es können auch andere wasserlösliche Eisensalze verwendet werden, beispielsweise Eisenperchlorat. Vorteilhaft sind Salze, die keine biologisch nicht oder schwer abbaubaren (harten) Komplexbildner enthalten, da diese Probleme bei der Spülwasserentsorgung bereiten können (beispielsweise Eisenammoniumalaun). Die Verwendung von Eisenverbindungen mit Anionen, die bei der Kupferabscheidelösung zu unerwünschten Nebenreaktionen führen, wie beispielsweise Chlorid oder Nitrat, sollten möglichst nicht eingesetzt werden. Günstig sind daher auch Carboxylate des Eisens wie Acetat, Propionat und Benzoat, sowie die Hexafluorosilikate.

Als Anoden werden keine löslichen Anoden aus Kupfer eingesetzt, sondern dimensionsstabile, unlösliche Anoden. Durch Verwendung der dimensionsstabilen, unlöslichen Anoden kann ein konstanter Abstand zwischen den Anoden und den Wafern eingestellt werden. Die Anoden sind in ihrer geometrischen Form problemlos an die Wafer anpaßbar und verändern im Gegensatz zu löslichen Anoden ihre geometrischen Außenabmessungen praktisch nicht.

Dadurch bleibt der die Schichtdickenverteilung an der Oberfläche der Wafer beeinflussende Abstand zwischen den Anoden und den Wafern konstant.

Zur Herstellung unlöslicher Anoden werden gegenüber dem Elektrolyten widerstandsfähige (inerte) Materialien eingesetzt, wie beispielsweise Edelstahl oder Blei. Vorzugsweise werden Anoden verwendet, die als Grundwerkstoff Titan oder Tantal enthalten, das vorzugsweise mit Edelmetallen oder Oxiden der Edelmetalle beschichtet ist. Als Beschichtung werden beispielsweise Platin, Iridium oder Ruthenium sowie die Oxide oder Mischoxide dieser Metalle verwendet. Für die Beschichtung können neben Platin, iridium und Ruthenium grundsätzlich auch Rhodium, Palladium, Osmium, Silber und Gold bzw. deren Oxide und Mischoxide eingesetzt werden. Eine besonders hohe Widerstandsfähigkeit gegenüber den Elektrolysebedingungen konnte beispielsweise an einer Titananode mit einer Iridiumoxidoberfläche beobachtet werden, die mit feinen Partikeln, beispielsweise kugelförmigen Körpern, bestrahlt und dadurch porenfrei verdichtet wurde. Außerdem können selbstverständlich auch Anoden eingesetzt werden, die aus Edelmetallen bestehen, beispielsweise Platin, Gold oder Rhodium oder Legierungen dieser Metalle. Grundsätzlich können auch andere inerte elektrisch leitfähige Materialien wie Kohlenstoff (Graphit) eingesetzt werden.

Zur elektrolytischen Kupferabscheidung wird eine Spannung zwischen dem Halbleitersubstrat und der Anode angelegt, wobei die Spannung so gewählt wird, daß ein elektrischer Strom von 0,05 A bis 20 A, vorzugsweise 0,2 A bis 10 A und insbesondere 0,5 A bis 5 A, pro dm$^2$ Halbleitersubstratoberfläche fließt.

Da die bei der Abscheidung aus der Abscheidelösung verbrauchten Kupferionen durch die Anoden nicht unmittelbar durch Auflösung nachgeliefert werden können, werden diese durch chemische Auflösung von entsprechenden Kupferteilen oder Kupfer enthaltenden Formkörpern ergänzt. Durch die oxidierende Wirkung der in der Abscheidelösung enthaltenen Fe(III)-Verbindungen werden in einer Redoxreaktion Kupferionen aus den Kupferteilen oder Formkörpern gebildet.

Zur Ergänzung der durch Abscheidung verbrauchten Kupferionen wird daher ein Kupferionen-Generator eingesetzt, in dem Teile aus Kupfer enthalten sind. Zur Regenerierung der durch Verbrauch an Kupferionen verarmten Abscheidelösung wird diese an den Anoden vorbeigeführt, wobei sich Fe(III)-Verbindungen aus den Fe(II)-Verbindungen bilden. Anschließend wird die Lösung durch den Kupferionen-Generator hindurchgeleitet und dabei mit den Kupferteilen in Kontakt gebracht. Dabei reagieren die Fe(III)-Verbindungen mit den Kupferteilen unter Bildung von Kupferionen, d.h. die Kupferteile lösen sich auf. Gleichzeitig werden die Fe(III)-Verbindungen in die Fe(II)-Verbindungen überführt. Durch Bildung der Kupferionen wird die Gesamtkonzentration der in der Abscheidelösung enthaltenen Kupferionen konstant gehalten. Vom Kupferionen-Generator aus gelangt die Abscheidelösung wieder zurück in den mit den Wafern und den Anoden in Kontakt stehenden Elektrolytraum.

Durch diese spezielle Technik kann die Konzentration der Kupferionen in der Abscheidelösung sehr leicht konstant gehalten werden.

Für die Kupferabscheidung werden die Wafer üblicherweise horizontal gehalten. Dabei wird darauf geachtet, daß die Rückseite des Wafers nicht mit der Abscheidelösung in Kontakt kommt. Den Wafern sind Anoden im Abscheidebad, ebenfalls horizontal gehalten, direkt gegenüber angeordnet.

Das erfindungsgemäße Verfahren eignet sich insbesondere zum Bilden von Leiterbahnen, Verbindungskontaktierungen und Anschlußplätzen in an den Oberflächen von Wafern liegenden Vertiefungen. Üblicherweise werden die Oberflächen der Wafer vor der Bildung dieser metallischen Strukturen aus Siliziumdioxid gebildet. Zur Herstellung der Leiterbahnen und Verbindungskontaktierungen wird Kupfer hierzu in grabenartigen oder als Sackloch ausgebildeten Vertiefungen abgeschieden.

Um auf der dielektrischen Oberfläche der Siliziumdioxidschicht eine Kupferschicht galvanisch abscheiden zu können, muß erstere zunächst elektrisch leitend gemacht werden. Außerdem müssen geeignete Vorkehrungen getroffen werden, um die Diffusion von Kupferatomen in das darunterliegende Silizium zu verhindern.

Um eine Diffusionssperre zwischen der Kupferschicht und Silizium zu erzeugen wird daher beispielsweise eine Nitridschicht (beispielsweise Tantalnitridschicht) mit einem Sputterverfahren gebildet.

Anschließend wird die Grundmetallschicht erzeugt, die eine elektrisch leitfähige Grundlage für die anschließende galvanische Metallisierung bildet. Als Grundmetallschicht wird eine vorzugsweise 0,02 µm bis 0,3 µm dicke, ganzflächige Schicht erzeugt, vorzugsweise mit einem physikalischen Metallabscheideverfahren und/oder einem CVD-Verfahren und/oder einem PECVD-Verfahren. Grundsätzlich kann aber auch ein galvanotechnisches Verfahren, beispielsweise ein außenstromloses Metallabscheideverfahren, eingesetzt werden. Beispielsweise kann eine aus Kupfer bestehende Grundmetallschicht abgeschieden werden. Geeignet sind auch andere leitfähige Schichten, vorzugsweise Metallschichten.

Danach wird die etwa 1 µm dicke Kupferschicht nach dem vorstehend beschriebenen Verfahren galvanisch abgeschieden. Selbstverständlich kann diese Schicht auch dünner oder dicker sein, beispielsweise von 0,2 µm bis 5 µm.

Nach der Bildung dieser Kupferschicht wird die Struktur der Leiterbahnen, Verbindungskontaktierungen und Anschlußplätze übertragen. Hierzu können übliche Strukturierungsverfahren angewendet werden. Beispielsweise kann die gebildete Kupferschicht mit einer Resistschicht überzogen werden und anschließend durch Entfernen der Resistschicht an den Stellen wieder freigelegt werden, an denen keine Leiterbahnen, Verbindungskontaktierungen oder Anschlußplätze gebildet werden sollen. Schließlich wird die Kupferschicht in den freigelegten Bereichen entfernt.

In der als "Damaszener Kupfermetallisierung" bekannt gewordenen Verfahrensweise wird Kupfer insbesondere in den graben- bzw. lochartigen Vertiefungen abgeschieden und das sich auf der Oberfläche des Wafers außerhalb der Vertiefungen abgeschiedene Kupfer mit einem Polierverfahren, das auf mechanischen und chemischen Methoden beruht (CMP-Verfahren), selektiv entfernt.

Nachfolgend wird ein Beispiel für das erfindungsgemäße Verfahren angegeben.

Beispiel:

Zur Herstellung einer Kupferschicht wurde ein mit Vertiefungen (trenches, vias) versehener Wafer zuerst mit einer Diffusionsbarriere aus Tantalnitrid und anschließend mit einer etwa 0,1 µm dicken Kupferschicht, die beide mit Sputterverfahren gebildet wurden, überzogen. Zur weiteren Abscheidung der Kupferschicht mit dem erfindungsgemäßen Verfahren wurde ein Kupferabscheidebad mit folgender Zusammensetzung eingesetzt:

| | |
|---|---|
| $H_2SO_4$, 98 Gew.-% | 230 g/l |
| $CuSO_4 \cdot 5\ H_2O$ | 138 g/l |
| $FeSO_4 \cdot 7\ H_2O$ | 65 g/l |
| NaCl | 0,08 g/l |
| Sauerstoff enthaltende polymere Netzmittel in Wasser | |

Das Kupfer wurde unter folgenden Bedingungen abgeschieden:

| | |
|---|---|
| kathodische Stromdichte | 4 A/dm$^2$ |
| Umwälzleistung des Bades unlösliche Anoden Raumtemperatur | 5 l\min |

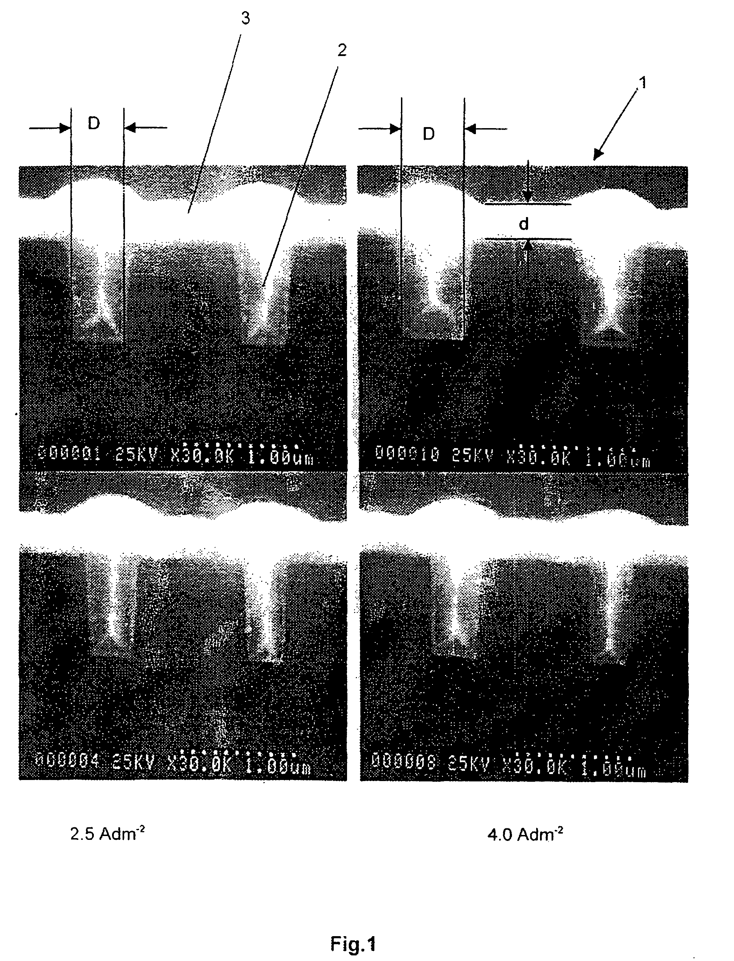

Das Beschichtungsergebnis ist an Hand von Querschliffen durch den Wafer **1** in **Fig. 1** gezeigt, der mit Kupfer **3** gefüllte Vertiefungen **2** mit unterschiedlichen Breiten **D** vor Durchführung eines CMP-Verfahrens aufweist. Auch die Oberflächen der erhabenen Stellen am Wafer **1** sind mit der Kupferschicht **3** überzogen. Die Kupferschichtdicke **d** über den Vertiefungen **2** ist überraschenderweise größer als über den erhabenen Stellen auf dem Wafer **1**. Dadurch ist es nicht sehr aufwendig, eine ebene Oberfläche des Wafers **1** mit dem CMP-Verfahren zu erreichen.

**Patentansprüche**

1. Verfahren zum galvanischen Bilden von Leiterstrukturen aus hochneimem Kupfer auf mit Vertiefungen versehenen Halbleitersubstratoberflächen bei der Herstellung von integrierten Schaltungen mit folgenden Verfahrensschritten:

   a. Beschichten der mit den Vertiefungen versehenen Halbleitersubstratoberflächen mit einer ganzflächigen Grundmetallschicht, um eine ausreichende Leitfähigkeit für die galvanische Abscheidung zu erzielen;
   b. ganzflächiges Abscheiden von Kupferschichten mit gleichmäßiger Schichtdicke auf der Grundmetallschicht mit einem galvanischen Metallabscheideverfahren durch In-Kontakt-Bringen der Halbleitersubstrate mit einem Kupferabscheidebad,

   i. wobei das Kupferabscheidebad mindestens eine Kupferionenquelle, mindestens eine Additivverbindung zur Steuerung der physikalisch-mechanischen Eigenschaften der Kupferschichten sowie Fe(II)-Verbindungen und/oder Fe(III)-Verbindungen enthält und
   ii. wobei zwischen den Halbleitersubstraten und dimensionsstabilen, in dem Bad unlöslichen und mit diesem in Kontakt gebrachten Gegenelektroden eine elektrische Spannung angelegt wird, so daß zwischen den Halbleitersubstraten und den Gegenelektroden ein elektrischer Strom fließt;

   c. Strukturieren der Kupferschicht.

2. Verfahren nach Anspruch 1, **dadurch gekennzeichnet, daß** der Strom mit einer zeitlichen Abfolge von uni- oder bipolaren Pulsen verändert wird.

**3.** Verfahren nach Anspruch 2, **dadurch gekennzeichnet, daß** der Strom mit einer zeitlichen Abfolge von bipolaren Pulsen, bestehend aus einer Folge von 20 Millisekunden bis 100 Millisekunden dauernden kathodischen und 0,3 Millisekunden bis 10 Millisekunden dauernden anodischen Pulsen, verändert wird.

**4.** Verfahren nach einem der Ansprüche 2 und 3, **dadurch gekennzeichnet, daß** im Falle bipolarer Pulse der Peakstrom der anodischen Pulse auf mindestens denselben Wert eingestellt wird wie der Peakstrom der kathodischen Pulse.

**5.** Verfahren nach einem der Ansprüche 2 bis 4, **dadurch gekennzeichnet, daß** im Falle bipolarer Pulse der Peakstrom der anodischen Pulse zwei- bis dreimal so hoch eingestellt wird wie der Peakstrom der kathodischen Pulse.

**6.** Verfahren nach einem der vorstehenden Ansprüche, **dadurch gekennzeichnet, daß** mindestens eine Additivverbindung verwendet wird, ausgewählt aus der Gruppe, bestehend aus polymeren Sauerstoff enthaltenden Verbindungen, organischen Schwefelverbindungen, Thioharnstoffverbindungen und polymeren Phenazoniumverbindungen.

**7.** Verfahren nach einem der vorstehenden Ansprüche, **dadurch gekennzeichnet, daß** mit Edelmetallen oder Oxiden der Edelmetalle beschichtete inerte Metalle als dimensionsstabile, unlösliche Gegenelektroden eingesetzt werden.

**8.** Verfahren nach Anspruch 7, **dadurch gekennzeichnet, daß** mit fridiumoxid beschichtetes und mittels feiner Partikel bestrahltes Titan-Streckmetall als Gegenelektrode eingesetzt wird.

**9.** Verfahren nach einem der vorstehenden Ansprüche, **dadurch gekennzeichnet, daß** die Konzentration der Verbindungen der Kupferionenquelle im Kupferabscheidebad zeitlich konstant gehalten wird, indem Kupferteile oder Kupfer enthaltende Formkörper mit dem Kupferabscheidebad in Kontakt gebracht und Kupfer durch Reaktion mit im Bad enthaltenen Fe(III)-Verbindungen und/oder Fe(III)-ionen aufgelöst wird.

**Claims**

**1.** Method for the electrolytic formation of conductor structures from extremely pure copper on semiconductor substrate surfaces provided with depressions, during the production of integrated circuits, said method having the following steps:

a. coating the semiconductor substrate surfaces, which are provided with depressions, with a basic metal layer over their entire surface in order to achieve a sufficient conductivity for the electrodeposition;
b. depositing onto the entire surface of the basic metal layer copper layers of uniform layer thickness using an electrodeposition method, by bringing the semiconductor substrates into contact with a copper deposition bath,

i. wherein the copper deposition bath contains at least one source of copper ions, at least one additive compound to control the physical-mechanical properties of the copper layers, as well as Fe(II) compounds and/or Fe(III) compounds, and
ii. wherein an electrical voltage is applied between the semiconductor substrates and dimensionally stable counter-electrodes, which are insoluble in the bath and are brought into contact with said bath, such that an electrical current flows between the semiconductor substrates and the counter-electrodes;

c. structuring the copper layer.

**2.** Method according to claim 1, **characterised in that** the current is varied with a chronological sequence of unipolar or bipolar pulses.

**3.** Method according to claim 2, **characterised in that** the current is varied with a chronological sequence of bipolar pulses, comprising a sequence of cathodic pulses which last 20 milliseconds to 100 milliseconds and anodic pulses which last 0.3 milliseconds to 10 milliseconds.

**4.** Method according to one of claims 2 and 3, **characterised in that** in the case of bipolar pulses, the peak current of the anodic pulses is set to at least the same value as the peak current of the cathodic pulses.

5. Method according to one of claims 2 to 4, **characterised in that** in the case of bipolar pulses, the peak current of the anodic pulses is set two to three times as high as the peak current of the cathodic pulses.

6. Method according to one of the preceding claims, **characterised in that** at least one additive compound is used, selected from the group comprising polymeric compounds which contain oxygen, organic sulphur compounds, thiourea compounds and polymeric phenazonium compounds.

7. Method according to one of the preceding claims, **characterised in that** inert metals coated with noble metals or oxides of the noble metals are used as the dimensionally stable, insoluble counter-electrodes.

8. Method according to claim 7, **characterised in that** titanium expanded metal, which is coated with iridium oxide and irradiated by means of fine particles, is used as the counterelectrode.

9. Method according to one of the preceding claims, **characterised in that** the concentration of the compounds of the source of copper ions in the copper deposition bath is kept constant over time, by copper parts or formed pieces containing copper being brought into contact with the copper deposition bath and copper being dissolved by reaction with Fe(III) compounds and/or Fe(III) ions contained in the bath.


**Revendications**

1. Procédé pour la formation galvanique de structures conductrices en cuivre de grande pureté sur des surfaces de substrats de semi-conducteurs prévus avec des cavités lors de la fabrication de circuits intégrés avec les étapes du procédé suivantes :

   a. Recouvrement des surfaces des substrats des semi-conducteurs prévues avec les cavités, avec une couche métallique de base totalement plane, pour obtenir une conductibilité suffisante pour la déposition galvanique ;
   b. Déposition totalement plane de couches de cuivre avec épaisseur homogène des couches sur la couche métallique de base avec un procédé de déposition métallique galvanique par mise en contact des substrats des semi-conducteurs avec un bain de déposition du cuivre,

      i. sachant que le bain de déposition du cuivre contient au moins une source d'ions de cuivre, au moins un composé d'additifs pour la commande des propriétés physiques et mécaniques des couches de cuivre ainsi que des composés Fe (II) et/ou des composés Fe(III) et
      ii. sachant qu'entre les substrats des semi-conducteurs et les contre-électrodes insolubles dans le bain et mises en contact avec celui-ci une tension électrique est exercée, de sorte qu'un courant électrique passe entre les substrats des semi-conducteurs et les contre-électrodes.

      c. Structuration de la couche de cuivre.

2. Procédé selon la revendication 1, **caractérisé en ce que** le courant est modifié avec un train temporaire d'impulsions unipolaires ou bipolaires.

3. Procédé selon la revendication 2, **caractérisé en ce que** le courant est modifié avec un train temporaire d'impulsions bipolaires, se composant d'une suite d'impulsions cathodiques durant de 20 millisecondes à 100 millisecondes et d'impulsions anodiques durant de 0,3 millisecondes à 10 millisecondes.

4. Procédé selon l'une des revendications 2 et 3, **caractérisé en ce qu'**en cas d'impulsions bipolaires le courant de pointe des impulsions anodiques est réglé sur au moins la même valeur que le courant de pointe des impulsions cathodiques.

5. Procédé selon l'un des revendications 2 à 4, **caractérisé en ce qu'**en cas d'impulsions bipolaires le courant de pointe des impulsions anodiques est réglé avec deux à trois fois la même puissance que le courant de pointe des impulsions cathodiques.

6. Procédé selon l'une des revendications précédentes, **caractérisé en ce qu'**au moins un composé d'additifs soit utilisé, extrait du groupe, se composant de composés polymère contenant de l'oxygène, de composés organiques sulfurés, de composés de thio-urée et de composés de phénazonium polymère.

7. Procédé selon l'une des revendications précédentes, **caractérisé en ce que** les métaux inertes recouverts de métaux précieux ou d'oxydes de métaux précieux sont posés comme des contre-électrodes insolubles et stables au niveau dimensionnel.

8. Procédé selon la revendication 7, **caractérisé en ce que** le métal de titane déployé recouvert d'oxyde d'iridium et irradié par de fines particules est posé comme une contre-électrode.

9. Procédé selon l'une des revendications précédentes, **caractérisé en ce que** la concentration des composés de la source d'ions de cuivre est maintenue temporairement constante dans le bain de déposition du cuivre, alors que le corps de moule contenant des éléments en cuivre ou du cuivre est mis en contact avec le bain de déposition du cuivre et le cuivre est dissous par réaction avec des composés Fe (III) et/ou des ions Fe (III).

2.5 Adm$^{-2}$

4.0 Adm$^{-2}$

Fig.1

13